(19) Europäisches Patentamt
European Patent Office
Office européen des brevets

(11) **EP 4 203 013 A1**

(12) **EUROPEAN PATENT APPLICATION**
published in accordance with Art. 153(4) EPC

(43) Date of publication:
**28.06.2023 Bulletin 2023/26**

(21) Application number: **21875549.4**

(22) Date of filing: **27.09.2021**

(51) International Patent Classification (IPC):
**H01L 23/36** (2006.01)      **H01L 23/373** (2006.01)

(52) Cooperative Patent Classification (CPC):
**H01L 23/36; H01L 23/373**

(86) International application number:
**PCT/JP2021/035449**

(87) International publication number:
**WO 2022/071247 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.09.2020 JP 2020163275**

(71) Applicant: **Denka Company Limited**
**Tokyo 103-8338 (JP)**

(72) Inventors:
• **MINAKATA, Yoshitaka**
**Tokyo 103-8338 (JP)**

• **WAKUDA, Yusuke**
**Tokyo 103-8338 (JP)**
• **KANEKO, Masahide**
**Tokyo 103-8338 (JP)**
• **SAKAGUCHI, Shinya**
**Tokyo 103-8338 (JP)**
• **YAMAGUCHI, Tomoya**
**Tokyo 103-8338 (JP)**

(74) Representative: **Hoffmann Eitle**
**Patent- und Rechtsanwälte PartmbB**
**Arabellastraße 30**
**81925 München (DE)**

(54) **COMPOSITE SHEET AND MANUFACTURING METHOD THEREOF, AND LAMINATE AND MANUFACTURING METHOD THEREOF**

(57)    Provided is a composite sheet including a porous nitride sintered body having a thickness of less than 2 mm and a resin filled in pores of the nitride sintered body, wherein a filling rate of the resin is 85% by volume or more. Provided is a method for manufacturing a composite sheet including an impregnation step of impregnating pores of a porous nitride sintered body having a thickness of less than 2 mm with a resin composition having a viscosity of 10 to 500 mPa·s to obtain a resin-impregnated body, and a curing step of heating the resin-impregnated body to semi-cure the resin composition filled in the pores.

*Fig.1*

**Description**

**Technical Field**

The present disclosure relates to a composite sheet and a manufacturing method thereof, and a laminate and a manufacturing method thereof.

**Background Art**

In components such as power devices, transistors, thyristors, and CPUs efficiently dissipation of heat generated during use thereof is required. In response to such demands, attempts have been made to increase thermal conductivity of an insulating layer of a printed wiring board on which an electronic component is mounted, and to attach the electronic component or the printed wiring board to a heat sink via thermal interface materials having electrical insulating properties. For such an insulating layer and thermal interface materials, a composite composed of a resin and ceramics such as boron nitride is used as a heat dissipation member.

As such a composite, a composite obtained by impregnating a porous ceramic sintered body (for example, a boron nitride sintered body) with a resin has been studied (for example, see Patent Literature 1). In addition, in a laminate including a circuit board and a resin impregnated boron nitride sintered body, direct contact between primary particles constituting the boron nitride sintered body and the circuit board has been studied to reduce thermal resistance of the laminate and improve heat dissipation (for example, see Patent Literature 2).

**Citation List**

**Patent Literature**

Patent Literature 1: PCT International Publication No. WO2014/196496
Patent Literature 2: Japanese Unexamined Patent Publication No. 2016-103611

**Summary of Invention**

**Technical Problem**

With recent high integration of circuits in semiconductor devices and the like, miniaturization of components has been demanded. Along with this, the contact area between members is becoming smaller. Under such circumstances, in order to ensure reliability, it is considered necessary to improve adhesiveness between members made of different materials.

Accordingly, the present disclosure provides a composite sheet which is easily miniaturized and has excellent adhesiveness, and a manufacturing method thereof. In addition, the present disclosure provides a laminate having excellent adhesion reliability even when the laminate is miniaturized by using the composite sheet, and a manufacturing method thereof.

**Solution to Problem**

According to an aspect of the present disclosure, there is provided a composite sheet including: a porous nitride sintered body having a thickness of less than 2 mm; and a resin filled in pores of the nitride sintered body, wherein a filling rate of the resin is 85% by volume or more. The "filling rate of the resin" in the present disclosure is a volume ratio of pores filled with the resin to the entire pores of the nitride sintered body. Since the thickness of the composite sheet is less than 2 mm, it is easy to miniaturize the composite sheet. In addition, since the filling rate of the resin is sufficiently high, when the composite sheet is bonded to another member by heating and pressing, resin component is sufficiently exuded from the inside of the composite sheet. The exuded resin component contributes to the improvement of the adhesiveness. Therefore, the composite sheet can be easily miniaturized and has excellent adhesiveness.

The average pore diameter of pores of the nitride sintered body in the composite sheet may be 0.5 to 5 $\mu$m. At least part of the pores of the nitride sintered body of the present disclosure may be filled with the resin. When the average pore diameter of the pores is within the above range, the amount of exudation during bonding can be sufficiently increased to further improve the adhesiveness, and the thermal conductivity can be increased.

At least a part of protruding portions of an uneven structure on the main surface may be formed of the resin.

Accordingly, the resin constituting the protruding portion is softened or dissolved at the time of bonding, thereby contributing to an improvement in adhesiveness. Therefore, the adhesiveness can be further increased.

The nitride sintered body may contain a boron nitride sintered body. Boron nitride has high thermal conductivity, insulation, and the like. Therefore, the composite sheet containing the boron nitride sintered body can be suitably used as a component of semiconductor devices or the like.

According to an aspect of the present disclosure, there is provided a laminate including the composite sheet and the metal laminated to each other. Since the laminate includes the above-described composite sheet, the adhesiveness between the composite sheet and the metal sheets is excellent. Therefore, the adhesion reliability is excellent even if the size is reduced.

In one aspect, the present disclosure provides a method for manufacturing a composite sheet, the method including: an impregnation step of impregnating pores of a porous nitride sintered body having a thickness of less than 2 mm with a resin composition having a viscosity of 10 to 500 mPa·s to obtain a resin-impregnated body; and a curing step of heating the resin-impregnated body to semi-cure the resin composition filled in the pores.

In the above-described manufacturing method, since the porous nitride sintered body having a thickness of less than 2 mm is used and the resin composition having a predetermined viscosity is used, the pores of the nitride sintered body can be sufficiently impregnated with the resin composition. When the composite sheet obtained by semi-curing the resin composition in the resin-impregnated body is bonded to another member by heating and pressing, the resin component included in the semi-cured product is sufficiently exuded from the inside of the composite sheet. The resin component exuded in this manner contributes to improvement of the adhesiveness. Therefore, according to the manufacturing method, it is possible to manufacture a composite sheet which is easily miniaturized and has excellent adhesiveness. The filling rate of a resin of the composite sheet obtained by the manufacturing method may be 85% by volume or more.

In the manufacturing method, an average pore diameter of the pores of the nitride sintered body may be 0.5 to 5 $\mu$m. Accordingly, it is possible to increase the strength of the composite sheet, sufficiently increase the amount of resin component exuded during bonding, further improve the adhesiveness, and increase the thermal conductivity.

In the curing step, the resin composition adhering to the main surface of the resin-impregnated body may be semi-cured to form a protruding portion made of resin on the main surface. The resin constituting the protruding portion formed in this manner contributes to improvement of the adhesiveness with other members. Therefore, the adhesiveness can be further improved.

The nitride sintered body may contain a boron nitride sintered body. Boron nitride has high thermal conductivity, insulation, and the like. Therefore, the composite sheet containing the boron nitride sintered body can be suitably used as a component of semiconductor devices or the like.

In one aspect, the present disclosure provides a method for manufacturing a laminate including a lamination step of laminating a composite sheet and a metal sheet, the composite sheet being obtained by the above-described method for manufacturing, and heating and pressing the composite sheet and the metal sheet. Since the laminate obtained by such a manufacturing method uses the above-described composite sheet, the laminate has excellent adhesiveness between the composite sheet and the metal sheets. Therefore, it is possible to manufacture a laminate having excellent adhesion reliability even when the laminate is miniaturized.

**Advantageous Effects of Invention**

According to the present disclosure, it is possible to provide a composite sheet which can be easily miniaturized and has excellent adhesiveness, and a manufacturing method thereof. Further, according to the present disclosure, by using such a composite sheet, it is possible to provide a laminate having excellent adhesion reliability even when the laminate is miniaturized, and a manufacturing method thereof.

**Brief Description of Drawings**

[FIG. 1] FIG. 1 is a perspective view of a composite sheet according to an embodiment.
[FIG. 2] FIG. 2 is a scanning microscope photograph showing an example of a cross section obtained by cutting the composite sheet along the thickness direction.
[FIG. 3] FIG. 3 is a cross-sectional view of a laminate according to an embodiment.

**Description of Embodiments**

Hereinafter, some embodiments of the present disclosure will be described with reference to the drawings as necessary. However, the following embodiments are examples for describing the present disclosure, and are not intended to limit the present disclosure to the following contents.

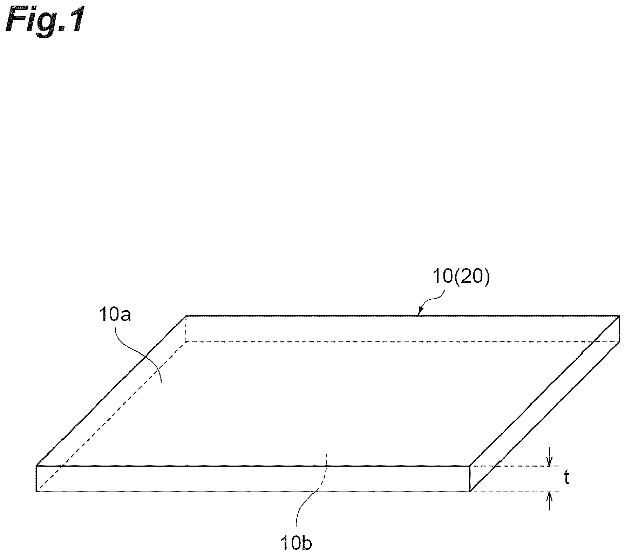

FIG. 1 is a perspective view of a composite sheet 10 according to an embodiment. The composite sheet 10 includes a porous nitride sintered body 20 having a thickness t of less than 2 mm and a resin filled in pores of the nitride sintered body 20. The nitride sintered body 20 contains nitride particles formed by the primary particles of the nitride being sintered together, and the pores.

The resin filling rate in the composite sheet 10 is 85% by volume or more. This makes it possible to sufficiently increase exudation of the resin component at the time of bonding by heating and pressing. Accordingly, the composite sheet of the present embodiment has excellent adhesiveness. From the viewpoint of further enhancing the adhesiveness, the resin filling rate may be 88% by volume or more, may be 90% by volume or more, and may be 92% by volume or more.

The "resin" in the present disclosure is a semi-cured product (B-stage) of a resin composition containing a main agent and a curing agent. The semi-cured product is a product in which a curing reaction of the resin composition partially proceeds. Accordingly, the resin may contain a thermosetting resin generated by the reaction of the main agent and the curing agent in the resin composition. The semi-cured product may contain monomers of the main agent, the curing agent, and the like in addition to the thermosetting resin as a resin component. It can be confirmed by, for example, a differential scanning calorimeter that the resin contained in the composite sheet is the semi-cured product (B-stage) before complete curing (C-stage). The curing rate of the resin determined by the method described in Examples may be 10% to 70% and may be 20% to 60%.

The resin may contain at least one selected from the group consisting of epoxy resin, silicone resin, cyanate resin, silicone rubber, acrylic resin, phenol resin, melamine resin, urea resin, bismaleimide resin, unsaturated polyester, fluororesin, polyimide, polyamideimide, polyetherimide, polybutylene terephthalate, polyethylene terephthalate, polyphenylene ether, polyphenylene sulfide, wholly aromatic polyester, polysulfone, liquid crystal polymer, polyethersulfone, polycarbonate, maleimide resin, maleimide-modified resin, acrylonitrile-butadienestyrene (ABS) resin, acrylonitrile-acrylic rubber-styrene (AAS) resin, acrylonitrile-ethylene-propylene-diene rubber-styrene (AES) resin, polyglycolic acid resin, polyphthalamide, and polyacetal. The resin may contain one of them alone or may contain two or more of them in combination.

When the composite sheet 10 is used for an insulating layer of a printed wiring board, the resin may contain epoxy resins from the viewpoint of improving heat resistance and adhesive strength to a circuit. When the composite sheet 10 is used for a thermal interface material, the resin may contain silicone resins from the viewpoint of improving heat resistance, flexibility, and adhesion to a heat sink or the like.

The volume fraction of the resins in the composite sheet 10 may be 30 to 60% by volume, or 35 to 55% by volume, with respect to the total volume of the composite sheet 10. The volume fraction of the nitride particles constituting the nitride sintered body 20 in the composite sheet 10 may be 40 to 70% by volume, or 45 to 65% by volume, with respect to the total volume of the composite sheet 10. The composite sheet 10 having such a volume fraction can achieve both excellent adhesiveness and strength at high levels.

The average pore diameter of the pores of the nitride sintered body 20 may be 5 $\mu$m or less, 4 $\mu$m or less, or even 3.5 $\mu$m or less. In such a nitride sintered body 20, since the size of pores is small, the contact area between the nitride particles can be sufficiently increased. Therefore, the thermal conductivity can be increased. The average pore diameter of the pores of the nitride sintered body 20 may be 0.5 $\mu$m or more, 1 $\mu$m or more, or 1.5 $\mu$m or more. Since such a nitride sintered body 20 can be sufficiently deformed when pressurized at the time of bonding, the amount of exudation of the resin component can be increased. Therefore, the adhesiveness can be further improved.

The average pore diameter of pores in the nitride sintered body 20 can be measured by the following procedure. First, the composite sheet 10 is heated to remove the resin. Then, the pore diameter distribution when the nitride sintered body 20 is pressurized while increasing pressures from 0.0042 MPa to 206.8 MPa is obtained using a mercury-porosimeter. When the horizontal axis represents pore diameter and the vertical axis represents cumulative pore volume, the pore diameter at which the cumulative pore volume reaches 50% of the total pore volume is the average pore diameter. As the mercury-porosimeter, one manufactured by SHIMADZU CORPORATION can be used.

The porosity of the nitride sintered body 20, that is, the ratio of the volumes (V1) of pores in the nitride sintered body 20, may be 30 to 65% by volume, and may be 40 to 60% by volume. If the porosity is too large, the strength of the nitride sintered body tends to decrease. On the other hand, if the porosity is too small, the amount of the resin exuded when the composite sheet 10 is bonded to another member tends to be small.

The porosity can be determined from a bulk density [B (kg/m$^3$)] calculated from the volume and mass of the nitride sintered body 20 and a theoretical density of nitride [A (kg/m$^3$)], using the following expression (1). The nitride sintered body 20 may contain at least one selected from the group consisting of boron nitride, aluminum nitride, and silicon nitride. In the case of boron nitride, the theoretical density A is 2280 kg/m$^3$. In the case of aluminum nitride, the theoretical density A is 3260 kg/m$^3$. In the case of silicon nitride, the theoretical density A is 3170 kg/m$^3$.

$$\text{Porosity (\% by volume)} = [1 - (B / A)] \times 100 \quad (1)$$

When the nitride sintered body 20 is a boron nitride sintered body, the bulk density B may be 800 to 1500 kg/m$^3$, and may be 1000 to 1400 kg/m$^3$. If the bulk density B becomes too small, the strength of the nitride sintered body 20 tends to decrease. On the other hand, if the bulk density B becomes too large, the amount of filled resin decreases, and the amount of the resin exuded when the composite sheet 10 is bonded to another member tends to decrease.

The thickness t of the nitride sintered body 20 may be less than 2 mm, and may be less than 1.6 mm. Pores of the nitride sintered body 20 having such a thickness can be sufficiently filled with resin. Therefore, it is possible to reduce the size of the composite sheet 10 and improve the adhesiveness of the composite sheet 10. Such a composite sheet 10 is suitably used as components of semiconductor devices. From the viewpoint of facilitating the production of the nitride sintered body 20, the thickness t of the nitride sintered body 20 may be 0.1 mm or more, and may be 0.2 mm or more.

The thickness of the composite sheet 10 may be the same as the thickness t of the nitride sintered body 20 or may be larger than the thickness t of the nitride sintered body 20. The thickness of the composite sheet 10 may be less than 2 mm, and may be less than 1.6 mm. The thickness of the composite sheet 10 may be 0.1 mm or more, and may be 0.2 mm or more. The thickness of the composite sheet 10 is measured along a direction perpendicular to main surfaces 10a and 10b. When the thickness of the composite sheet 10 is not constant, the thickness is measured by randomly selecting ten points, and the mean value thereof may be within the above-described range. When the thickness of the nitride sintered body 20 is not constant, the thickness is measured by randomly selecting ten points, and the mean value thereof is the thickness t. The size of the main surfaces 10a and 10b of the composite sheet 10 is not particularly limited, and may be, for example, 500 mm$^2$ or more, 800 mm$^2$ or more, or 1000 mm$^2$ or more.

The main surface 10a and the main surface 10b of the composite sheet 10 are preferably not cut surfaces. Accordingly, the ratio of the nitride sintered body 20 exposed to the main surface 10a and the main surface 10b can be reduced, and the resin-covering ratio can be sufficiently increased. As a result, the adhesiveness to other members laminated on the main surface 10a and the main surface 10b can be improved. The main surfaces 10a and 10b of the composite sheet 10 may have an uneven structure. In this case, protruding portions of the main surfaces 10a and 10b may be formed of the resin. This can further improve the adhesiveness of other members and the like. The maximum value of the height of the protruding portion with respect to the recessed portion may be, for example, 15 $\mu$m or less, and may be 10 $\mu$m or less.

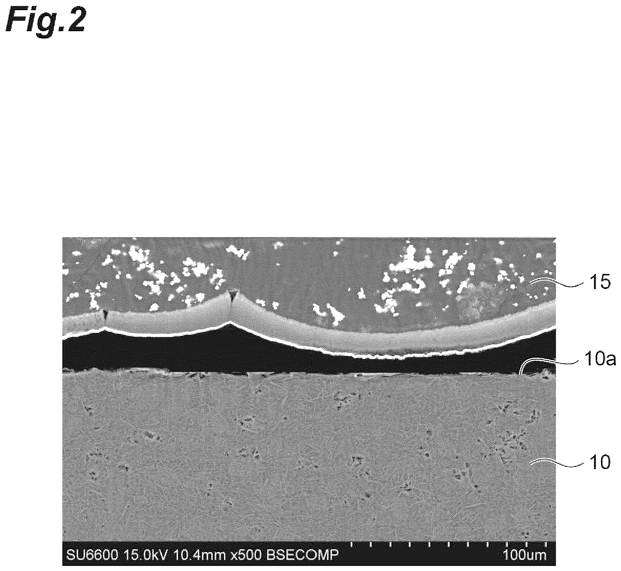

FIG. 2 is a scanning electron microscope photograph showing an example of a cross section obtained by cutting the composite sheet 10 along the thickness direction. The main surface 10a of the composite sheet 10 shown in FIG. 2 is not a cut surface. Therefore, a part of the protruding portion in the main surface 10a of the composite sheet 10 is made of resin. The black portion in the center portion (above the main surface 10a) of the photograph in FIG. 2 is a space, and a portion 15 shown above the black portion indicates equipment used for observation with the scanning microscope. A part of the protruding portion in the main surface 10b that is not a cut surface may also be formed of resin.

Although the main surface 10a and the main surface 10b of the composite sheet 10 in the present embodiment have a square shape, the shape is not limited thereto. For example, the main surfaces may be a polygon other than a square, or may be a circle. The main surfaces may be a shape in which corner portions are chamfered or a shape in which a portion is cut out. The main surfaces may have a through hole penetrating in the thickness direction.

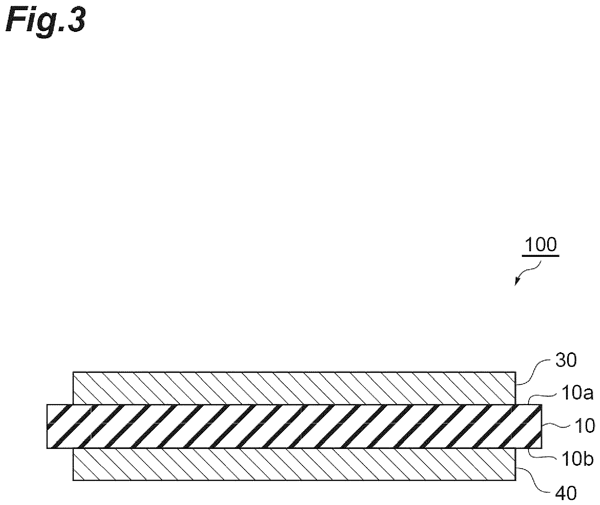

FIG. 3 is a cross-sectional view of a laminate 100 according to an embodiment taken along the thickness direction. The laminate 100 includes the composite sheet 10, a metal sheet 30 bonded to the main surface 10a of the composite sheet 10, and a metal sheet 40 bonded to the main surface 10b of the composite sheet 10. The metal sheets 30 and 40 may be a metallic plate or a metallic foil. Examples of the material of the metal sheets 30 and 40 include aluminum and copper. The material and thickness of the metal sheets 30 and 40 may be the same or different. It is not essential to include both of the metal sheets 30 and 40, and a modification of the laminated body 100 may include only one of the metal sheets 30 and 40.

The laminate 100 may have a resin layer between the composite sheet 10 and the metal sheets 30 and 40. The resin layer may be formed by curing the resin exuded from the composite sheet 10. Since the composite sheet 10 and the metal sheets 30 and 40 in the laminate 100 are sufficiently strongly bonded with the exuded resin, the adhesion reliability is excellent. Since such a laminate is thin and has excellent adhesion reliability, the laminate can be suitably used for semiconductor devices or the like as a heat dissipation member, for example.

A method for manufacturing a composite sheet according to an embodiment includes a sintering step of preparing a porous nitride sintered body, an impregnation step of impregnating pores of the nitride sintered body having a thickness of less than 2 mm with a resin composition having a viscosity of 10 to 500 mPa·s to obtain a resin-impregnated body, and a curing step of heating the resin-impregnated body to semi-cure the resin composition filled in the pores.

Raw material powder used in the sintering step contains nitride. The nitride contained in the raw material powder may contain, for example, at least one nitride selected from the group consisting of boron nitride, aluminum nitride, and silicon nitride. In the case where boron nitride is contained, the boron nitride may be amorphous boron nitride or hexagonal boron nitride. When a boron nitride sintered body is prepared as the nitride sintered body 20, for example, amorphous boron nitride powder having an average particle diameter of 0.5 to 10 $\mu$m or hexagonal boron nitride powder having an average particle diameter of 3.0 to 40 $\mu$m can be used as the raw material powder.

In the sintering step, blend containing the nitride powder may be molded and sintered to obtain the nitride sintered body. The molding may be carried out by uniaxial pressing or by cold isostatic pressing (CIP). Prior to molding, a sintering aid may be blended to obtain the blend. Examples of the sintering aid include metal oxides such as yttria oxide, aluminum oxide, and magnesium oxide; alkali metal carbonates such as lithium carbonate and sodium carbonate; and boric acid. When the sintering aid is blended, the blending amount of the sintering aid may be, for example, 0.01 parts by mass or more, or 0.1 parts by mass or more with respect to 100 parts by mass in total of the nitride and the sintering aid. The blending amount of the sintering aid may be, for example, 20 parts by mass or less, 15 parts by mass or less, or 10 parts by mass or less with respect to 100 parts by mass in total of the nitride and the sintering aid. When the amount of sintering aid added is within the above range, the average pore diameter of the nitride sintered body can be easily adjusted to the range described below.

The blend may be formed into a sheet-shaped molded body by a doctor blade method, for example. The molding method is not particularly limited, and a molded body may be obtained by performing press molding using a mold. The molding pressure may be, for example, 5 to 350 MPa. The shape of the molded body may be a sheet shape having a thickness of less than 2 mm. When a nitride sintered body is produced using such a sheet-shaped molded body, a sheet-shaped composite sheet having a thickness of less than 2 mm can be produced without cutting the nitride sintered body. In addition, compared to a case in which a block-shaped nitride sintered body is cut into a sheet shape, material loss due to processing can be reduced by forming the molded body into a sheet shape from the stage of the molded body. Therefore, the composite sheet can be manufactured with a high yield.

The sintering temperature in the sintering step may be, for example, 1600°C or more, and may be 1700°C or more. The sintering temperature may be, for example, 2200°C or less, and may be 2000°C or less. The sintering time may be, for example, 1 hour or more and 30 hours or less. The atmosphere during sintering may be, for example, an inert gas atmosphere such as nitrogen, helium, and argon.

For the sintering, for example, a batch furnace, a continuous furnace, or the like can be used. Examples of the batch furnace include a muffle furnace, a tubular furnace, and an atmospheric furnace. Examples of the continuous furnace include a rotary kiln, a screw conveyor furnace, a tunnel furnace, a belt furnace, a pusher furnace, and a large continuous furnace. In this way, the nitride sintered body can be obtained. The nitride sintered body may be block-shaped.

When the nitride sintered body has a block shape, a cutting step of processing the nitride sintered body to have a thickness less than 2 mm is performed. In the cutting step, the nitride sintered body is cut using, for example, a wire saw. The wire saw may be, for example, a multi-cut wire saw or the like. By such a cutting step, for example, a sheet-like nitride sintered body having a thickness of less than the 2 mm can be obtained. The nitride sintered body thus obtained has a cut surface.

When the cutting step of the nitride sintered body is performed, fine cracks may be generated in the cut surface. On the other hand, since the composite sheet obtained without performing the cutting step of the nitride sintered body does not have a cut surface, fine cracks can be sufficiently reduced. Therefore, the composite sheet obtained without performing the cutting step of the nitride sintered body can sufficiently improve insulation and thermal conductivity while maintaining sufficiently high strength. That is, it has excellent reliability as a member of electronic components or the like. Further, when processing such as cutting is performed, material loss occurs. Therefore, the composite sheet having no cut surface of the nitride sintered body can reduce the material loss. Accordingly, the yield of the nitride sintered body and the composite sheet can be improved.

In the impregnation step, pores of the nitride sintered body 20 having a thickness of less than 2 mm are impregnated with a resin composition having a viscosity of 10 to 500 mPa·s to obtain the resin-impregnated body. Since the nitride sintered body 20 is in the form of a sheet having a thickness of less than the 2 mm, the resin composition is easily impregnated into the inside thereof. In addition, the resin filling rate can be sufficiently increased by adjusting the viscosity of the resin composition impregnated into the nitride sintered body 20 to be within a range suitable for impregnation.

The viscosity of the resin composition when the nitride sintered body 20 is impregnated with the resin composition may be 440 mPa·s or less, may be 390 mPa·s or less, or may be 340 mPa·s or less. By lowering the viscosity of the resin composition in this manner, impregnation of the resin composition can be sufficiently promoted. The viscosity of the resin composition when the nitride sintered body 20 is impregnated with the resin composition may be 15 mPa·s or more, and may be 20 mPa·s or more. By setting the lower limit to the viscosity of the resin composition in this manner, the resin composition once impregnated into the pores can be prevented from flowing out from the pores. The viscosity of the resin composition may be adjusted by partially polymerizing the monomer components. The viscosity of the resin composition is a viscosity at a temperature (T1) of the resin composition when the nitride sintered body 20 is impregnated with the resin composition. The viscosity is measured using a rotational viscometer at a shear rate of 10 (1/sec) under temperature (T1) conditions. Accordingly, the viscosity of the resin composition when the nitride sintered body 20 is impregnated with the resin composition may be adjusted by changing the temperature T1.

The temperature (T1) when the nitride sintered body 20 is impregnated with the resin composition may be, for example, equal to or higher than a temperature (T2) at which the resin composition is semi-cured and lower than a temperature T3 (= T2 + 20°C). The temperature (T2) may be, for example, 80 to 140°C. Impregnation of the nitride sintered body 20 with the resin composition may be performed under pressure or reduced pressure. The impregnation method is not particularly limited, and may be performed by immersing the nitride sintered body 20 in the resin composition or by applying the resin composition to the surfaces of the nitride sintered body 20.

By using a resin composition having a viscosity within the above range, the resin filling rate in the composite sheet 10 can be made sufficiently high. The resin filling rate may be, for example, 85% by volume or more, 88% by volume or more, 90% by volume or more, or 92% by volume or more.

The impregnation step may be performed under either a reduced pressure condition or a pressurized condition, or may be performed by combining impregnation under a reduced pressure condition and impregnation under a pressurized condition. When the impregnation step is carried out under the reduced pressure condition, the pressure in a impregnation apparatus may be, for example, 1000 Pa or less, 500 Pa or less, 100 Pa or less, 50 Pa or less, or 20 Pa or less. When the impregnation step is performed under the pressurized condition, the pressures in the impregnation apparatus may be, for example, 1 MPa or more, 3 MPa or more, 10 MPa or more, or 30 MPa or more.

Impregnation of the resin composition by the capillary phenomenon may be promoted by adjusting the pore diameter of the pores in the nitride sintered body 20. From such a viewpoint, the average pore diameter of the nitride sintered body 20 may be 0.5 to 5 $\mu$m, and may be 1 to 4 $\mu$m.

As the resin composition, for example, a composition which becomes the resin described in the description of the composite sheet through a curing or semi-curing reaction can be used. The resin composition may contain a solvent. The viscosity of the resin composition may be adjusted by changing the blending amount of the solvent, or the viscosity of the resin composition may be adjusted by partially advancing the curing reaction. Examples of the solvent include aliphatic alcohols such as ethanol and isopropanol, ether alcohols such as 2-methoxyethanol, 1-methoxyethanol, 2-ethoxyethanol, 1-ethoxy-2-propanol, 2-butoxyethanol, 2-(2-methoxyethoxy)ethanol, 2-(2-ethoxyethoxy) ethanol, 2-(2-butoxyethoxy) ethanol, and the like, glycol ethers such as ethylene glycol monomethyl ether, ethylene glycol monobutyl ether, and the like, ketones such as acetone, methyl ethyl ketone, methyl isobutyl ketone, diisobutyl ketone, and the like, and hydrocarbons such as toluene, xylene, and the like. The solvent may contain one of them alone or may contain two or more of them in combination.

The resin composition is thermosetting and may contain, for example, at least one compound selected from the group consisting of a compound having a cyanate group, a compound having a bismaleimide group, and a compound having an epoxy group, and a curing agent.

Examples of the compound having a cyanate group include dimethylmethylene bis(1,4-phenylene)biscyanate, bis(4-cyanatephenyl)methane, and the like. Dimethylmethylene bis(1,4-phenylene)biscyanate is commercially available, for example, as, TACN (manufactured by MITSUBISHI GAS CHEMICAL COMPANY, INC., trade name).

Examples of the compound having a bismaleimide group include N,N'-[(1-methylethylidene)bis[(p-phenylene)oxy(p-phenylene)]]bismaleimide, 4,4'-diphenylmethane bismaleimide, and the like. N,N'-[(1-methylethylidene)bis[(p-phenylene)oxy(p-phenylene)]]bismaleimide is commercially available, for example, as BMI-80 (manufactured by K.I Chemical Industry Co., Ltd., trade name).

Examples of the compound having an epoxy group include a bisphenol F type epoxy resin, a bisphenol A type epoxy resin, a biphenyl type epoxy resin, a polyfunctional epoxy resin, and the like. For example, 1,6-bis(2,3-epoxypropan-1-yloxy)naphthalene or the like that is commercially available as HP-4032D (manufactured by DIC Corporation, trade name) may be exemplified.

The curing agent may include a phosphine-based curing agent and an imidazole-based curing agent. The phosphine-based curing agent may promote a triazine-generating reaction by trimerization of the compound having a cyanate group or a cyanate resin. Examples of the phosphine-based curing agent include tetraphenyl phosphonium tetra-p-tolyl borate, tetraphenyl phosphonium tetraphenyl borate, and the like. Tetraphenyl phosphonium tetra-p-tolyl borate is commercially available, for example, as TPP-MK (manufactured by HOKKO CHEMICAL INDUSTRY CO., LTD., trade name).

The imidazole-based curing agent generates oxazoline and promotes a curing reaction of the compound having an epoxy group or an epoxy resin. Examples of the imidazole-based curing agent include 1-(1-cyanomethyl)-2-ethyl-4-methyl-1H-imidazole, 2-ethyl-4-methylimidazole, and the like. 1-(1-Cyanomethyl)-2-ethyl-4-methyl-1H-imidazole is commercially available, for example, as 2E4MZ-CN (manufactured by SHIKOKU CHEMICALS CORPORATION, trade name).

The content of the phosphine-based curing agent may be, for example, 5 parts by mass or less, 4 parts by mass or less, or 3 parts by mass or less, with respect to 100 parts by mass of the total amount of the compound having a cyanate group, the compound having a bismaleimide group, and the compound having an epoxy group. The content of the phosphine-based curing agent may be, for example, 0.1 parts by mass or more or 0.5 parts by mass or more, with respect to 100 parts by mass of the total amount of the compound having a cyanate group, the compound having a bismaleimide group, and the compound having an epoxy group. When the content of the phosphine-based curing agent is within the above range, the resin-impregnated body can be easily prepared, and the time required for bonding the composite sheet cut out from the resin-impregnated body to another member can be further shortened.

The content of the imidazole-based curing agent may be, for example, 0.1 parts by mass or less, 0.05 parts by mass or less, or 0.03 parts by mass or less, with respect to 100 parts by mass of the total amount of the compound having a cyanate group, the compound having a bismaleimide group, and the compound having an epoxy group. The content of the imidazole-based curing agent may be, for example, 0.001 parts by mass or more or 0.005 parts by mass or more, with respect to 100 parts by mass of the total amount of the compound having a cyanate group, the compound having a bismaleimide group, and the compound having an epoxy group. When the content of the imidazole-based curing agent is within the above range, the resin-impregnated body can be easily prepared, and the time required for bonding the composite sheet cut out from the resin-impregnated body to the adherend can be further shortened.

The resin composition may contain components other than the main agent and the curing agent. As the other components, for example, at least one selected from the group consisting of other resins such as a phenol resin, a melamine resin, a urea resin, and an alkyd resin, a silane coupling agent, a leveling agent, an antifoaming agent, a surface conditioner, a wetting dispersant, and the like may be further contained. The content of these other components may be, for example, 20% by mass or less, 10% by mass or less, or 5% by mass or less in total, with respect to the total amount of the resin composition.

The impregnation step is followed by a curing step of semi-curing the resin composition impregnated in the pores. In the curing step, the resin composition is semi-cured by heating and/or light irradiation depending on the type of the resin composition (or curing agent added as necessary). "Semi-cured" (also referred to as B-stage) refers to those that can be further cured by a subsequent curing treatment. The composite sheet and the metal sheets may be temporarily pressure-bonded to other members such as the metal sheets by utilizing the semi-cured state, and then heated to bond the composite sheet and the metal sheets. The semi-cured product is further cured into a "fully cured" (also referred to as a C-stage) state.

In the curing step, when the resin composition is semi-cured by heating, the heating temperature may be, for example, 80 to 130°C. The semi-cured product obtained by semi-curing the resin composition may contain, as the resin component, at least one thermosetting resin selected from the group consisting of a cyanate resin, a bismaleimide resin, and an epoxy resin, and a curing agent. The semi-cured product may contain, as a resin component, components derived from, for example, other resins such as a phenol resin, a melamine resin, a urea resin, and an alkyd resin, as well as a silane coupling agent, a leveling agent, an antifoaming agent, a surface conditioner, a wetting dispersant, and the like.

The composite sheet obtained in this manner has a thickness of, for example, 2 mm or less. Therefore, it is thin and lightweight, and when it is used as a component of semiconductor devices or the like, the devices can be made compact and lightweight. Further, since the pores of the nitride sintered body are sufficiently filled with the resin, not only the adhesiveness but also the thermal conductivity and the insulating property are excellent. Further, in the above-described manufacturing method, the composite sheet can be manufactured without cutting the nitride sintered body. Therefore, a composite sheet having excellent reliability can be manufactured at a high yield. The composite sheet may be laminated with metal sheets to form a laminate, or may be used as a heat dissipation member as it is.

In the curing step, the resin composition attached to the main surfaces of the resin-impregnated body may be semi-cured to form protruding portions made of resin on the main surface. By having such protruding portions, the adhesiveness to the adherend can be further improved.

A method for manufacturing a laminate according to an embodiment includes a lamination step of laminating a composite sheet and metal sheets, and heating and pressing the composite sheet and the metal sheets. The composite sheet may be manufactured by the above-described manufacturing method. The metal sheets may be metal plates or may be metal foils.

In the lamination step, the metal sheet is arranged on the main surfaces of the composite sheet. While the main surfaces of the composite sheet and the metal sheet are brought into contact with each other, the composite sheet and the metal sheet are pressurized and heated in a direction in which the main surfaces face each other. Pressurization and heating do not necessarily need to be performed at the same time, and heating may be performed after pressurization and pressure bonding. The pressurizing force may be, for example, 2 to 10 MPa. In this case, when the temperature at which the resin composition is semi-cured is T2, a heating temperature T4 may satisfy $T4 \geq T2 + 20°C$, or may satisfy $T4 \geq T2 + 40°C$. Accordingly, the resin composition exuded from the composite sheet is cured at the interface between the composite sheet and the metal sheet, so that the composite sheet and the metal sheet can be firmly bonded to each other. From the viewpoint of preventing decomposition of the cured product, the heating temperature T4 may satisfy $T4 \leq T2 + 150°C$ and may satisfy $T4 \leq T2 + 100°C$.

The laminate thus obtained can be used for manufacturing semiconductor devices or the like. A semiconductor element may be provided on one metal sheet. Another metal sheet may be joined with cooling fins.

Although several embodiments have been described above, the present disclosure is not limited to the above-described embodiments. For example, in the sintering step, a nitride sintered body may be obtained by hot pressing in which molding and sintering are simultaneously performed.

**Examples**

The contents of the present disclosure will be more specifically described with reference to Examples and Comparative Examples; however, the present disclosure is not limited to the following Examples.

(Example 1)

<Production of nitride sintered body>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible and heated in an arc furnace in an argon atmosphere at 2200°C for 5 hours to obtain lump boron carbide ($B_4C$). The obtained lump product was coarsely pulverized with a jaw crusher to obtain a coarse powder. This coarse powder was further pulverized with a ball mill having silicon carbide beads ($\phi$10 mm) to obtain a pulverized powder.

The prepared pulverized powder was filled in a boron nitride crucible. Thereafter, the crucible was heated for 10 hours using a resistance heating furnace in a nitrogen gas atmosphere under the conditions of 2000°C and 0.85 MPa. In this way, a fired product containing boron carbonitride ($B_4CN_4$) was obtained.

Powdery boric acid and calcium carbonate were blended to prepare a sintering aid. Upon the preparation, 50.0 parts by mass of calcium carbonate was blended with respect to 100 parts by mass of boric acid. Regarding the atomic ratio of boron and calcium at this time, the atomic ratio of calcium was 17.5 atom% with respect to 100 atom% of boron. 20 parts by mass of the sintering aid was blended with respect to 100 parts by mass of the fired product and mixed using a Henschel mixer to prepare a powdery blend.

The blend was pressurized using a powder pressing machine at 150 MPa for 30 seconds to obtain a molded body having a sheet shape (length × width × thickness = 50 mm × 50 mm × 1.5 mm). The molded body was put in a boron nitride container and introduced into a batch-type high-frequency furnace. In the batch-type high-frequency furnace, heating was performed for 5 hours under the conditions of normal pressure, a nitrogen flow rate of 5 L/min, and 2000°C. Thereafter, a boron nitride sintered body was extracted from the boron nitride container. In this way, a sheet-shaped (quadrangular prism-shaped) boron nitride sintered body was obtained. The thickness of the boron nitride sintered body was 1.6 mm. The thickness t was measured with a caliper.

<Measurement of average pore diameter>

The pore volume distribution of the obtained boron nitride sintered body was measured using a mercury-porosimeter manufactured by SHIMADZU CORPORATION (device name: Autopore IV9500) while increasing the pressure from 0.0042 MPa to 206.8 MPa. The pore diameter at which the cumulative pore volume reached 50% of the total pore volume was taken as the "average pore diameter". Results were as shown in Table 1.

<Measurement of porosity>

The volume and mass of the obtained boron nitride sintered body were measured, and the bulk the density B ($kg/m^3$) were calculated from the volumes and masses. From this bulk density and the theoretical density (2280 $kg/m^3$) of boron nitride, the porosity was obtained by the following expression (2). Results were as shown in Table 1.

$$\text{Porosity (\% by volume)} = [1 - (B / 2280)] \times 100 \qquad (2)$$

<Production of composite sheet>

A resin composition was prepared by blending 10 parts by mass of a commercially available curing agent (manufactured by Nippon Synthetic Chemical Industry Co., Ltd., trade name: Akumex H-8) with 100 parts by mass of a commercially available epoxy resin (manufactured by Mitsubishi Chemical Corporation, trade name: Epikote 807). The prepared resin composition was heated at 120°C for 15 minutes, and then added dropwise to the main surface of the boron nitride sintered body heated to 120°C using a dropper while maintaining the temperature. The viscosity of the dropped resin composition was measured using a rotational viscometer, and results were shown in Table 1. The shear rate at the time of measurement was set to 10 (1/sec), and the measuring temperature was set to the temperature (120°C) at the time of dropping. Under atmospheric pressure, the resin composition dropped on the main surfaces of the boron nitride sintered body was spread by using a rubber spatula, and the resin composition was spread on the entire main surfaces to obtain a resin-impregnated body.

The resin-impregnated body was heated at 160°C for 30 minutes under atmospheric pressure to semi-cure the resin composition. In this manner, a quadrangular prism-shaped composite sheet (length × width × thickness = 50 mm × 50 mm × 1.6 mm) was produced. The size of the composite sheet was measured with a caliper.

The curing rate of the resin constituting the semi-cured product was determined by the following procedure. First, the temperature of one gram of resin composition before curing (uncured) was raised, and a calorific value Q (J/g) generated until complete curing was measured using a differential scanning calorimeter. Next, the temperature of one gram of composite sheet was similarly raised, and the calorific value R (J/g) generated until complete curing was measured using the same differential scanning calorimeter. The composite sheet was heated at 600°C for 1 hour to volatilize the resin component, and a content c (% by weight) of the thermosetting components contained in the composite sheet was determined from the difference in weight before and after heating.

Using the calorific values Q, R, and the content c obtained by the above-described procedure, the curing rate of the resins contained in the composite sheet was obtained by the following expression (3). As a result, the curing rate of the resin was 35%.

$$\text{Curing rate (\%)} = \{1 - [(R / c) \times 100] / Q\} \times 100 \qquad (3)$$

<Measurement of filling rate of resin (semi-cured product)>

The filling rate of the resin contained in the composite sheet was obtained by the following expression (4). Results were as shown in Table 1.

resin filling rate (% by volume) in the composite sheet = {(bulk density of composite sheet - bulk density of boron nitride sintered body) / (theoretical density of composite sheet - bulk density of boron nitride sintered body)} × 100 (4)

The bulk densities of the boron nitride sintered body and the composite sheet were determined in accordance with JIS Z 8807:2012 "Method for measuring density and specific gravity by geometric measurement" based on the volume calculated from the length of each side of the boron nitride sintered body or the composite sheet (measured with a caliper) and the mass of the boron nitride sintered body or the composite sheet measured with an electronic balance (see JIS Z 8807:2012, section 9). The theoretical density of the composite sheet was obtained by the following expression (5).

Theoretical density of composite sheet = true density of boron nitride sintered body + true density of resin × (1 - bulk density of boron nitride sintered body / true density of boron nitride) (5)

The true densities of the boron nitride sintered body and the resin were determined from the volumes and masses of the boron nitride sintered body and the resin measured using a dry automatic density meter in accordance with "Method for measuring density and specific gravity by gas displacement method" in JIS Z 8807:2012 (see expressions (14) to (17) in section 11 of JIS Z 8807:2012).

<Preparation of laminate>

The above-described composite sheet (length × width × thickness = 50 mm × 20 mm × 1.6 mm) was disposed between a sheet-shaped copper foil (length × width × thickness = 100 mm × 20 mm × 0.035 mm) and a sheet-shaped copper plate (length × width × thickness = 100 mm × 20 mm × 1 mm) to prepare a laminate including the copper foil, the composite sheet, and the copper plate in this order. The laminate was heated and pressurized at 200°C and 5 MPa for 5 minutes, and then heat-treated at 200°C and atmospheric for 2 hours. Thus, the laminate was obtained.

<Evaluation of adhesive strength>

After the above-described heat treatment was performed, a 90° peeling test was performed in accordance with JIS K 6854-1:1999 "Adhesives-Determination of peel strength of bonded assemblies-" using a universal testing machine (manufactured by A&D Company, Limited, trade name: RTG-1310). The 90° peeling test was performed at the bonding interface between the sheet-like copper foil and the composite sheet. The measurement was performed under conditions of a test speed of 50 mm/min, a load cell of 5 kN, and a measuring temperature of room temperature (20°C) to measure the area ratio of the cohesive failure portion on the peeling surface. Based on the measurement results, the adhesiveness was evaluated according to the following criteria. Results were as shown in Table 1. Note that the cohesive failure portion is not peeling at the interface between the composite sheet and the copper foil, but is a portion that is broken inside the composite sheet. The larger the area ratio of the broken portion in the composite sheet is, the more excellent the adhesiveness is.

A: The area ratio of the cohesive failure portion is 70% by area or more.
B: The area ratio of the cohesive failure portion is 50% by area or more and less than 70% by area.
C: The area ratio of the cohesive failure portion is less than 50% by area.

(Example 2)

A boron nitride sintered body was produced by the same procedure as that described in "Production of nitride sintered body" of Example 1 except that the size of the sheet-shaped molded body was set to length × width × thickness = 50 mm × 50 mm × 1.7 mm, the sintering aid was prepared by mixing 30 parts by weight of calcium carbonate with 100 parts by weight of boric acid, and 15 parts by weight of the sintering aid was added to 100 parts by weight of the fired product. The thickness t, average pore diameter and porosity of the obtained boron nitride sintered body were measured in the same manner as in Example 1. The thickness t of the boron nitride sintered body was 1.8 mm. Results were as shown in Table 1.
A resin-impregnated body and a composite sheet were produced in the same manner as in "Production of composite sheet" in Example 1 except that the heating time of the resin composition at 120°C was changed from 15 minutes to 30 minutes. The viscosity of the dropped resin composition is shown in Table 1. Since the heating time of the resin composition was longer than that in Example 1, the viscosity was higher. The filling rate of the resin (semi-cured product) of the prepared composite sheet was measured in the same manner as in Example 1. Results were as shown in Table 1. The thickness of the composite sheet measured with a caliper was 1.8 mm. Using the produced composite sheet, a laminate was produced in the same procedure as in Example 1, and the adhesive strength was evaluated. Results were as shown in Table 1.

(Example 3)

A boron nitride sintered body was produced by the same procedure as that described in "Production of nitride sintered body" of Example 1 except that the size of the sheet-shaped molded body was changed to length × width × thickness = 50 mm × 50 mm × 0.19 mm, the sintering aid was prepared by mixing 20 parts by weight of calcium carbonate with 100 parts by weight of boric acid, and 12 parts by weight of sintering aid was added to 100 parts by weight of the fired product. The thickness t, average pore diameter and porosity of the obtained boron nitride sintered body were measured in the same manner as in Example 1. The thickness t of the boron nitride sintered body was 0.2 mm. Results were as shown in Table 1.
A resin-impregnated body and a composite sheet were produced in the same manner as in "Production of composite sheet" in Example 1 except that the heating time of the resin composition at 120°C was changed from 15 minutes to about 30 minutes. As shown in Table 1, the viscosity of the dropped resin composition was slightly higher than that of Example 2. This seems to be because the heating time was slightly longer than that in Example 2. The content of the resin (semi-cured product) of the prepared composite sheet was measured in the same manner as in Example 1. Results were as shown in Table 1. The thickness of the composite sheet measured with a caliper was 0.2 mm. Using the produced composite sheet, a laminate was produced in the same procedure as in Example 1, and the adhesive strength was evaluated. Results were as shown in Table 1.

(Comparative Example 1)

A boron nitride sintered body was produced by the same procedure as that described in "Production of nitride sintered body" in Example 1 except that the size of the molded body was changed to length × width × thickness = 50 mm × 50 mm × 39.1 mm. The viscosity of the dropped resin composition, and the thickness t, average pore diameter and porosity of the obtained boron nitride sintered body were measured in the same manner as in Example 1. The thickness t of the boron nitride sintered body was 41.2 mm. Results were as shown in Table 1.
A resin-impregnated body and a composite (the composite sheet in Example 1) were prepared in the same manner as in Example 1. The content of the semi-cured product of the prepared composite was measured in the same manner as in Example 1. Results were as shown in Table 1. In addition, a laminate was produced by the same procedure as in Example 1 using the produced composite, and the adhesive strength was evaluated. Results were as shown in Table 1.

(Comparative Example 2)

A boron nitride sintered body was produced by the same procedure as that described in "Production of nitride sintered body" in Example 1 except that the molded body had a size of length × width × thickness = 50 mm × 50 mm × 48.6 mm, 20 parts by weight of calcium carbonate was added to 100 parts by weight of boric acid, and 12 parts by weight of sintering aid was added to 100 parts by weight of the sintered body. The viscosity of the dropped resin composition and the thickness t, average pore diameter and porosity of the obtained boron nitride sintered body were measured in the same manner as in Example 1. The thickness t of the boron nitride sintered body was 51.2 mm. Results were as shown in Table 1.

A resin-impregnated body and a composite (the composite sheet in Example 1) were produced by the same procedure as in "Production of composite sheet" in Example 1. The content of the semi-cured product of the prepared composite was measured in the same manner as in Example 1. Results were as shown in Table 1. In addition, a laminate was produced by the same procedure as in Example 1 using the produced composite, and the adhesive strength was evaluated. Results are as shown in Table 1.

(Comparative Example 3)

A boron nitride sintered body was produced by the same procedure as that described in "Production of nitride sintered body" in Example 1 except that the size of the molded body was changed to length × width × thickness = 50 mm × 50 mm × 56.3 mm. The viscosity of the dropped resin composition and the thickness t, average pore diameter and porosity of the obtained boron nitride sintered body were measured in the same manner as in Example 1. The thickness t of the boron nitride sintered body was 59.3 mm. Results were as shown in Table 1.

A resin-impregnated body and a composite (the composite sheet in Example 1) were produced in the same manner as in "Production of composite sheet" in Example 1 except that the heating time of the resin composition at 120°C was changed from 15 minutes to 30 minutes. The content of the semi-cured product of the prepared composite was measured in the same manner as in Example 1. Results were as shown in Table 1. In addition, a laminate was produced by the same procedure as in Example 1 using the produced composite, and the adhesive strength was evaluated. Results are as shown in Table 1.

Table 1

| | Boron nitride sintered body | | | Resin viscosity during impregnation [mPas@120°C] | Composite sheet | Laminate |
| | Thickness t [mm] | Average pore diameter [μm] | Porosity [% by volume] | | Resin filling rate [% by volume] | Evaluation of adhesive strength |
|---|---|---|---|---|---|---|
| Example 1 | 1.6 | 3.3 | 58 | 29 | 95.2 | A |
| Example 2 | 1.8 | 2.1 | 52 | 301 | 94.8 | A |
| Example 3 | 0.2 | 1.2 | 55 | 310 | 92.4 | B |
| Comparative Example 1 | 41.2 | 3.4 | 54 | 28 | 80.3 | C |
| Comparative Example 2 | 51.2 | 1.5 | 49 | 32 | 65.2 | C |
| Comparative Example 3 | 59.3 | 3.6 | 53 | 296 | 70.2 | C |

As shown in Table 1, in Examples 1 to 3 in which a boron nitride sintered body having a thickness t of 2 mm or less was used, the resin filling rate was higher than that in Comparative Examples 1 to 3.

**Industrial Applicability**

According to the present disclosure, a composite sheet which can be easily miniaturized and has excellent adhesiveness and a manufacturing method thereof are provided. In addition, according to the present disclosure, a laminate having excellent adhesion reliability even when miniaturized by using such a composite sheet and a manufacturing method thereof are provided.

**Reference Signs List**

10: composite sheet, 10a, 10b: main surface, 20: nitride sintered body, 30, 40: metal sheet, 100: laminate.

**Claims**

1.  A composite sheet comprising:

    a porous nitride sintered body having a thickness less than 2 mm; and
    a resin filled in pores of the nitride sintered body,
    wherein a filling rate of the resin is 85% by volume or more.

2.  The composite sheet according to claim 1, wherein an average pore diameter of the pores is 0.5 to 5 $\mu$m.

3.  The composite sheet according to claim 1 or 2, wherein at least a part of protruding portions of an uneven structure on a main surface is formed of the resin.

4.  The composite sheet according to any one of claims 1 to 3, wherein the nitride sintered body contains a boron nitride sintered body.

5.  A laminate comprising the composite sheet according to any one of claims 1 to 4 and a metal sheet laminated to each other.

6.  A method for manufacturing a composite sheet, the method comprising:

    an impregnation step of impregnating pores of a porous nitride sintered body having a thickness of less than 2 mm with a resin composition having a viscosity of 10 to 500 mPa·s to obtain a resin-impregnated body; and
    a curing step of heating the resin-impregnated body to semi-cure the resin composition filled in the pores.

7.  The method for manufacturing the composite sheet according to claim 6, wherein a filling rate of a resin is 85% by volume

8.  The method for manufacturing the composite sheet according to claim 6 or 7, wherein an average pore diameter of the pores of the nitride sintered body is 0.5 to 5 $\mu$m.

9.  The method for manufacturing the composite sheet according to any one of claims 6 to 8, wherein in the curing step, the resin composition adhering to a main surface of the resin-impregnated body is semi-cured to form a protruding portion made of resin on the main surface.

10. The method for manufacturing the composite sheet according to any one of claims 6 to 9, wherein the nitride sintered body contains a boron nitride sintered body.

11. A method for manufacturing a laminate comprising a lamination step of laminating a composite sheet and a metal sheet, the composite sheet being obtained by the method for manufacturing according to any one of claims 6 to 10, and heating and pressing the composite sheet and the metal sheet.

# Fig.1

10(20)

10a

10b

t

# Fig.2

SU6600 15.0kV 10.4mm x500 BSECOMP          100um

# *Fig.3*

100

30
10a
10
10b
40

## INTERNATIONAL SEARCH REPORT

| International application No. |
| --- |
| **PCT/JP2021/035449** |

**A. CLASSIFICATION OF SUBJECT MATTER**

*H01L 23/36*(2006.01)i; *H01L 23/373*(2006.01)i
FI: H01L23/36 M; H01L23/36 C; H01L23/36 D

According to International Patent Classification (IPC) or to both national classification and IPC

**B. FIELDS SEARCHED**

Minimum documentation searched (classification system followed by classification symbols)

H01L23/36; H01L23/373

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2017/155110 A1 (DENKA CO., LTD.) 14 September 2017 (2017-09-14) paragraphs [0016], [0028]-[0088], tables 1, 4 | 1-11 |
| X | WO 2018/181606 A1 (DENKA CO., LTD.) 04 October 2018 (2018-10-04) paragraphs [0001], [0019]-[0048], fig. 1-3 | 1-11 |
| X | WO 2014/196496 A1 (DENKI KAGAKU KOGYO KK) 11 December 2014 (2014-12-11) paragraphs [0030]-[0089] | 1, 3-4, 6-7, 9-10 |
| A | | 2, 5, 8, 11 |
| X | JP 2019-145744 A (IBIDEN CO., LTD.) 29 August 2019 (2019-08-29) paragraphs [0006], [0019]-[0056], fig. 1 | 1, 3-4, 6-7, 9-10 |
| A | | 2, 5, 8, 11 |
| A | JP 5-82760 B2 (IBIDEN CO., LTD.) 22 November 1993 (1993-11-22) column 4, line 38 to column 10, line 6 | 1-11 |

☐ Further documents are listed in the continuation of Box C.    ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **11 November 2021** | **22 November 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2021/035449**

| Patent document cited in search report | | | Publication date (day/month/year) | Patent family member(s) | | | Publication date (day/month/year) |
|---|---|---|---|---|---|---|---|
| WO | 2017/155110 | A1 | 14 September 2017 | US | 2019/0092695 | A1 | |
| | | | | paragraphs [0024], [0037]-[0107], tables 1, 4 | | | |
| | | | | EP | 3428223 | A1 | |
| | | | | KR | 10-2018-0124915 | A | |
| | | | | CN | 109153801 | A | |
| WO | 2018/181606 | A1 | 04 October 2018 | US | 2020/0031723 | A1 | |
| | | | | paragraphs [0001], [0031]-[0075], fig. 1-3 | | | |
| | | | | EP | 3605602 | A1 | |
| | | | | CN | 110168719 | A | |
| | | | | KR | 10-2019-0132395 | A | |
| WO | 2014/196496 | A1 | 11 December 2014 | US | 2016/0130187 | A1 | |
| | | | | paragraphs [0010]-[0112] | | | |
| | | | | EP | 3006419 | A1 | |
| | | | | CN | 105263886 | A | |
| | | | | KR | 10-2016-0016857 | A | |
| JP | 2019-145744 | A | 29 August 2019 | (Family: none) | | | |
| JP | 5-82760 | B2 | 22 November 1993 | US | 4882455 | A | |
| | | | | column 2, line 41 to column 6, line 21 | | | |
| | | | | EP | 196865 | A2 | |

Form PCT/ISA/210 (patent family annex) (January 2015)

**REFERENCES CITED IN THE DESCRIPTION**

**Patent documents cited in the description**

- WO 2014196496 A

- JP 2016103611 A